# EUROPEAN PATENT APPLICATION

(11) **EP 4 807 040 A1**
(43) Date of publication of application: **16.09.2026**
(21) Application number: 25221078.6
(22) Date of filing: 05.12.2025
(51) Int. Cl.: C23C 14/16, C23C 14/18, C23C 14/34, C23C 14/58, H01C 7/00, H01C 17/12, H10D 1/47

(54) **THIN FILM RESISTOR AND METHOD OF FORMING THE SAME**

(30) Priority: 14.03.2025 TW 114109537
(71) Applicant: Yageo Corporation, Kaohsiung City 811 (TW)
(72) Inventor: HSIAO, Shen-Li, 815 Kaohsiung City (TW); HOU, Min-Syuan, 815 Kaohsiung City (TW)
(74) Representative: Ström & Gulliksson AB

(57) **Abstract**

A thin film resistor and a method of forming the same are provided. The method includes forming an insulated oxide film on an upper surface of a substrate; forming a first inner electrode pair on two ends of the insulated oxide film; performing a DC multi-target hybrid sputtering operation to deposit a resistor layer on a portion of the insulated oxide film and a portion of the pair of first inner electrode; performing an RF-DC hybrid sputtering operation to deposit a doping layer over the resistor layer; performing an annealing operation so as to oxidize the doping layer to an oxidized doping film; and forming a passivation layer on the oxidized doping film. Therefore, resistance value and resistivity of the thin film resistor can be controlled.

## Description

### BACKGROUND

### Field of Invention

The present invention relates to a thin film resistor and a method of forming the same. More particularly, the present invention relates to the thin film resistor and the method of forming the same by using a DC multi-target hybrid sputtering operation.

### Description of Related Art

A resistor layer of the conventional thin film resistor is formed by sputtering single alloy target, so most resistor property depends on composition of a resistor target. Temperature coefficient of resistance of the resistor layer after sputtering can be adjusted by high-temperature annealing. However, resistivity of the resistor layer is limited by the target; thus, if the conventional thin film resistor desires for greater resistance value, the target material should be changed. If the target material cannot reach greater resistivity, the thin film resistor cannot achieve greater resistance value.

Therefore, it is needed to provide a thin film resistor and a method of forming the same, thereby adjusting resistance value of the thin film resistivity.

### SUMMARY

An aspect of the present invention provides a method of forming a thin film resistor, which uses a DC multi-target hybrid sputtering operation to deposit a resistor layer including different metals, thereby controlling resistance value of the thin film resistor.

Another aspect of the present invention provides a thin film resistor, which is formed by using above method.

According to the aspect of the present invention, the method of forming the thin film resistor is provided. The method includes forming an insulated oxide film on an upper surface of a substrate; forming a first inner electrode pair on two ends of the insulated oxide film; performing a DC multi-target hybrid sputtering operation to deposit a resistor layer on a portion of the insulated oxide film and a portion of the first inner electrode pair, in which the DC multi-target hybrid sputtering operation includes sputtering Ni-Cr alloy, tantalum and molybdenum; performing an RF-DC hybrid sputtering operation to deposit a doping layer over the resistor layer, in which the RF-DC hybrid sputtering operation includes RF sputtering silicon and DC sputtering aluminum; performing an annealing operation so as to oxidize the doping layer to form an oxidized doping film; and forming a passivation layer on the oxidized doping film.

According to an embodiment of the present invention, the operation of forming the insulated oxide film includes forming a sputtering layer on the substrate, in which the sputtering layer includes tantalum or silicon; and sintering the sputtering layer to form the insulated oxide film, in which the insulated oxide film includes tantalum oxide or silicon oxide.

According to an embodiment of the present invention, when performing the DC multi-target hybrid sputtering operation, a sputtering power of the tantalum is 60% to 100% of a sputtering power of the Ni-Cr alloy, and a sputtering power of the molybdenum is 5% to 30% of the sputtering power of the Ni-Cr alloy.

According to an embodiment of the present invention, when performing the RF-DC hybrid sputtering operation, a sputtering power of the aluminum is 20% to 50% of a sputtering power of the silicon.

According to an embodiment of the present invention, based on weight of the resistor layer as 100 wt%, the resistor layer includes 45 wt% to 75 wt% of the Ni-Cr alloy, 20 wt% to 40 wt% of the tantalum, and 5 wt% to 15 wt% of the molybdenum.

According to an embodiment of the present invention, a weight ratio of the aluminum and the silicon in the doping layer is 1:1 to 1:5.

According to an embodiment of the present invention, the method further includes forming a first insulated protective layer on the passivation layer; and forming a second inner electrode pair on the ends of the insulated oxide film, in which the first inner electrode pair and a portion of the first insulated protective layer are covered by the second inner electrode pair.

According to an embodiment of the present invention, the method further includes forming a second insulated protective layer on an exposed portion of the first insulated protective layer and a portion of the second inner electrode pair.

According to an embodiment of the present invention, the method further includes forming a back electrode pair on two ends of a lower surface of the substrate; and forming an outer electrode pair from the second insulated protective layer to the back electrode pair along two side portions of the substrate.

According to another aspect of the present invention, the thin film resistor, which is formed by the above method, is provided.

According to the aspect of the present invention, the method of forming the thin film resistor is provided. The method includes forming an insulated oxide film on an upper surface of a substrate; forming a first inner electrode pair on two ends of the insulated oxide film; performing a DC multi-target hybrid sputtering operation to deposit a resistor layer on a portion of the insulated oxide film and a portion of the first inner electrode pair; performing an RF-DC hybrid sputtering operation to deposit a doping layer over the resistor layer; performing an annealing operation so as to oxidize the doping layer to form an oxidized doping film, wherein the oxidized doping film includes aluminum oxide and silicon oxide; forming a passivation layer on the oxidized doping film; forming a first insulated protective layer on the passivation layer; and forming a second inner electrode pair on the ends of the insulated oxide film.

According to an embodiment of the present invention, the DC multi-target hybrid sputtering operation includes sputtering Ni-Cr alloy, tantalum and molybdenum.

According to an embodiment of the present invention, when performing the DC multi-target hybrid sputtering operation, a ratio of a sputtering power of the tantalum to a sputtering power of the Ni-Cr alloy is 0.6 to 1, and a ratio of a sputtering power of the molybdenum to the sputtering power of the Ni-Cr alloy is 0.05 to 0.3.

According to an embodiment of the present invention, the RF-DC hybrid sputtering operation includes RF sputtering silicon and DC sputtering aluminum, and a weight ratio of aluminum and silicon in the doping layer is 1:1 to 1:5.

According to an embodiment of the present invention, when performing the RF-DC hybrid sputtering operation, a ratio of a sputtering power of the aluminum to a sputtering power of the silicon is 0.2 to 0.5.

According to an embodiment of the present invention, the method further includes forming a first mask layer around the insulated oxide film and on a portion of the first inner electrode pair so as to expose an area to be sputtered on the substrate before performing the DC multi-target hybrid sputtering operation, wherein a ratio of a length of the area to be sputtered to a length of the substrate is 1/4 to 3/4, and a ratio of a width of the area to be sputtered to a width of the substrate is 2/5 to 4/5; and removing the first mask layer after depositing the doping layer.

According to an embodiment of the present invention, the annealing operation is performed with a heating temperature in a range from 300°C to 600°C and a duration time in a range from 2 hours to 6 hours.

According to an embodiment of the present invention, the method further includes forming a second mask layer around the insulated oxide film and on a portion of the first inner electrode pair so as to expose an area to be passivated on the substrate before forming the passivation layer, wherein a ratio of a length of the area to be passivated to a length of the substrate is 3/4 to 4/5, and a ratio of a width of the area to be passivated to a width of the substrate is 4/5 to 1; and removing the second mask layer after forming the passivation layer.

According to an embodiment of the present invention, the resistor layer has a thickness in a range from 0.02 µm to 0.5 µm, and the doping layer has a thickness in a range from 0.005 µm to 0.05 µm.

According to an embodiment of the present invention, the method further includes forming a second insulated protective layer on an exposed portion of the first insulated protective layer and a portion of the second inner electrode pair.

The thin film resistor and the method of forming the same of the present application is applied to deposit the resistor layer including different metals by using the DC multi-target hybrid sputtering operation, and to deposit the doping layer on the resistor layer by using the RF-DC hybrid sputtering operation, thereby controlling the resistance value and resistivity of the thin film resistor.

It is to be understood that both the foregoing general description and the following detailed description are by examples, and are intended to provide further explanation of the invention as claimed.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
Fig. 1 illustrates a cross-section view of a thin film resistor according to some embodiments of the present invention.
Figs. 2A-2I illustrate top views of a thin film resistor in intermediate stages of a fabrication process according to some embodiments of the present invention.

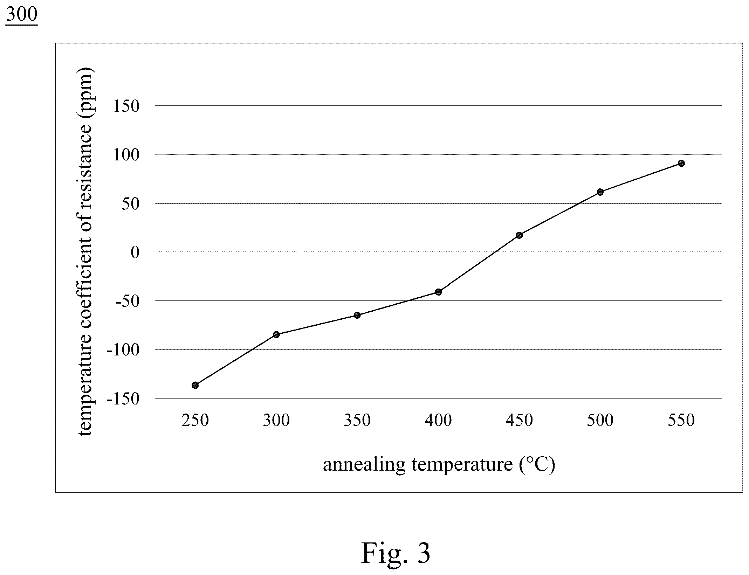

Fig. 3 illustrates a plot of temperature coefficient of resistance and annealing temperature according to some embodiments of the present invention.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

Fabrication and application of embodiments of the present invention are discussed in detail below. However, it is understood that the embodiments provide can applicable invention concepts, which can be implemented in a variety of specific contents. The discussed specific embodiments are only provided for illustrative purpose only and are not intended to limit the scope of the present invention.

As used herein, "around," "about," "approximately," or "substantially" shall generally mean within 20 percent, or within 10 percent, or within 5 percent of a given value or range.

According to above, the thin film resistor and the method of forming the same are provided. The resistor layer including different metals is deposited by using the DC multi-target hybrid sputtering operation, and the doping layer is deposited on the resistor layer by using the RF-DC hybrid sputtering operation, thereby controlling the resistance value and resistivity of the thin film resistor.

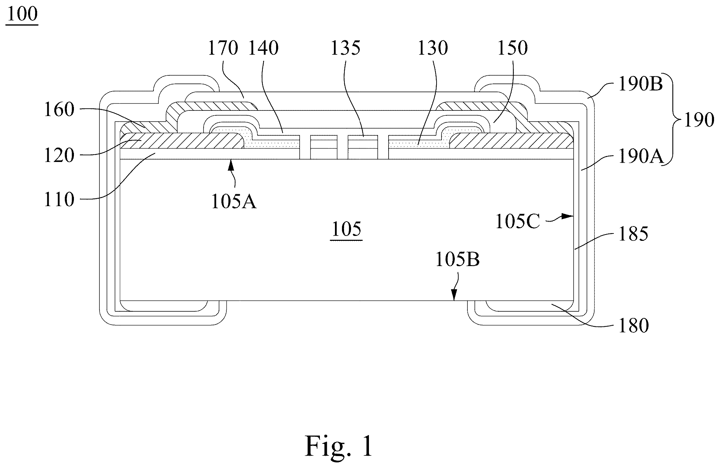

Referring to Fig. 1, Fig. 1 illustrates a cross-section view of a thin film resistor 100 according to some embodiments of the present invention. The thin film resistor 100 includes a substrate 105. In some embodiments, material of the substrate 105 includes ceramic material such as aluminum oxide (Al₂O₃), aluminum nitride (AIN), beryllium oxide (BeO), magnesium oxide (MgO), zirconia toughened alumina (ZTA), or combinations thereof.

The thin film resistor 100 includes an insulated oxide film 110 disposed on an upper surface 105A of the substrate 105. In some examples, the insulated oxide film 110 includes tantalum oxide (Ta₂O₅) or silicon oxide (SiO₂). The insulated oxide film 110 covers the upper surface 105A of the substrate 105 completely, thereby decreasing surface roughness of the substrate 105, and even increasing connection with a resistor layer 130.

The thin film resistor 100 includes a first inner electrode pair 120, the resistor layer 130, an oxidized doping film 135, a passivation layer 140, a first insulated protective layer 150, a second inner electrode pair 160 and a second insulated protective layer 170 disposed on the insulated oxide film 110. The first inner electrode pair 120 is disposed on two ends of the insulated oxide film 110. In some embodiments, material of the first inner electrode pair 120 includes glass, silver or an electrode paste formed by mixing silver and palladium or combinations thereof.

The resistor layer 130 is disposed on a portion of the insulated oxide film 110 uncovered by the first inner electrode pair 120 and a portion of the first inner electrode pair 120. In some embodiments, based on the resistor layer 130 as 100 wt%, the resistor layer 130 includes Ni-Cr alloy in a range from about 45 wt% to about 75 wt%, tantalum in a range from about 20 wt% to about 40 wt% and molybdenum in a range from 5 wt% to 15 wt%. Ni-Cr alloy is the main composition of the resistor layer 130, so the resistor layer 130 with the aforementioned range of Ni-Cr alloy can have suitable resistance value; the resistor layer 130 with the aforementioned range of tantalum can have moisture-resistance; and the resistor layer 130 with the aforementioned range of molybdenum can adjust the resistance value of the resistor layer 130. In some embodiments, the resistor layer 130 has a thickness in a range from about 0.02 µm to about 0.5 µm. The resistor layer 130 with the aforementioned thickness range can have suitable resistivity.

The oxidized doping film 135 is disposed on the resistor layer 130. In some embodiments, the oxidized doping film 135 includes silicon oxide and aluminum oxide. Portions of the silicon oxide and the aluminum oxide within the oxidized doping film 135 are diffused into the resistor layer 130 such that the temperature coefficient of resistance (TCR) and the resistivity of the resistor layer 130 can be adjusted.

The passivation layer 140 is disposed to completely cover the resistor layer 130. In some embodiments, the passivation layer 140 includes insulation material, such as silicon oxide, tantalum oxide, silicon nitride or combinations thereof.

The first insulated protective layer 150 is disposed on the passivation layer 140 and a portion of the first inner electrode pair 120. In some embodiments, material of the first insulated protective layer 150 includes resin, epoxy resin, epoxy resin including inorganic filler or combinations thereof.

The second inner electrode pair 160 is disposed on two ends of the insulated oxide film 110 and covers the first inner electrode pair 120 and a portion of the first insulated protective layer 150. The disposition of the second inner electrode pair 160 can protect the first inner electrode pair 120 from invasion of sulfur gas. In some embodiments, material of the second inner electrode pair 160 includes epoxy resin and silver.

The second insulated protective layer 170 is disposed on a portion of the first insulated protective layer 150 uncovered by the second inner electrode pair 160 and a portion of the second inner electrode pair 160. In some embodiments, material of the second insulated protective layer 170 includes resin, epoxy resin, epoxy resin including inorganic filler or combinations thereof.

The thin film resistor 100 further includes a back electrode pair 180 disposed on a lower surface 105B of the substrate 105. In some embodiments, the back electrode pair 180 is disposed on two ends of the lower surface 105B of the substrate 105. In some embodiments, material of the back electrode pair 180 includes epoxy resin and silver.

The thin film resistor 100 further includes connected layers 185 and an outer electrode pair 190. The connected layers 185 are disposed on side portions 105C of the substrate 105, and the outer electrode pair 190 extends from the second insulated protective layer 170 along the connected layer 185 to cover the back electrode pair 180. In some embodiments, material of the connected layer 185 includes Ni-Cr alloy. The outer electrode pair 190 includes nickel layer 190A and tin layer 190B.

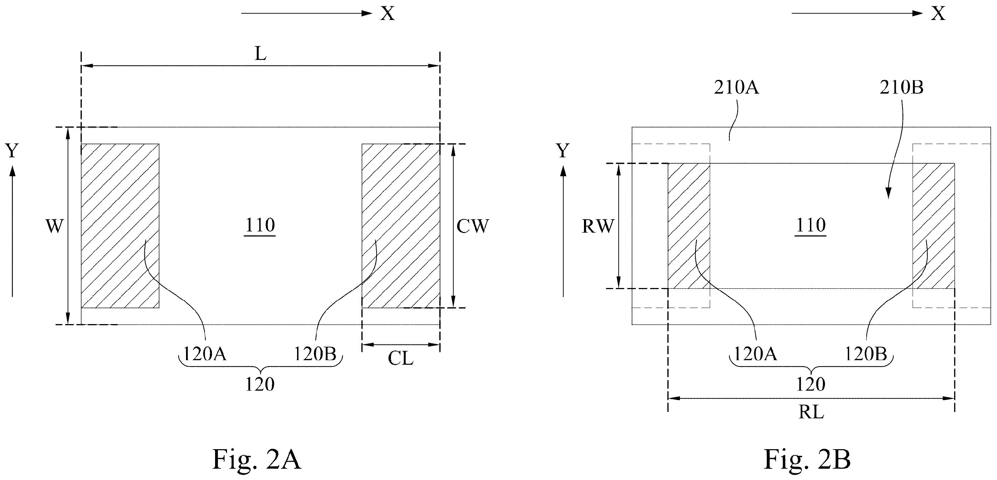

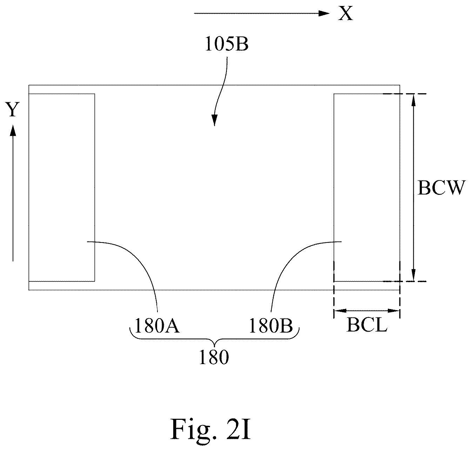

Figs. 2A-2I illustrate top views of the thin film resistor 100 at intermediate stages of the fabrication process according to some embodiments of the present invention, in which Figs. 2A-2H are top views looking downward from the upper surface 105A of the substrate 105 (referring to Fig. 1), while Fig. 2I is top view looking downward from the lower surface 105B of the substrate 105. The following discuss the fabrication process of the thin film resistor 100 by Figs. 2A-2I.

First, referring to Figs. 1 and 2A, the insulated oxide film 110 is formed on the substrate 105. In some embodiments, formation of the insulated oxide film 110 includes forming a sputtering layer on the substrate, and then sintering the sputtering layer to form the insulated oxide film 110. In the aforementioned embodiments, the sputtering layer has a thickness in a range from about 0.02 µm to about 0.1 µm, and such thickness can ensure the sputtering layer be completely oxidized after sintering. In some examples, the sputtering layer includes tantalum (Ta) or silicon (Si), so the insulated oxide film 110 includes tantalum oxide (Ta₂O₅) or silicon oxide (SiO₂). The tantalum oxide and the silicon oxide have better adhesion with the following formed resistor layer 130.

Subsequently, a first inner electrode 120A and a first inner electrode 120B (hereinafter referred to as the first inner electrode pair 120 in combination) are formed on the two ends of the insulated oxide film 110. In some embodiments, the first inner electrode pair 120 is formed by printing and sintering. The substrate 105 has a long edge along a direction X with a length L, and a short edge along a direction Y with a width W, and the first inner electrode pair 120 is disposed on the two ends of the long edge of the substrate 105. The first inner electrodes 120A and 120B have length CL along the direction X and width CW along the direction Y, respectively. In some embodiments, the length CL is about 1/5 to about 1/3 times the length L, and the width CW is about 4/5 to about 1 times the width W.

Referring to Fig. 2B, a mask layer 210A is formed around the insulated oxide film 110 and on a portion of the first inner electrode pair 120, so as to expose an area 210B to be sputtered. In some embodiments, the mask layer 210A is removable glass ink, and the mask layer 210A can be formed by, for example, printing, coating or film laminating. In some embodiments, the area 210B to be sputtered has a length RL in the direction X is about 1/4 to about 3/4 times the length L, and a width RW in the direction Y is about 2/5 to about 4/5 times the width W.

Subsequently, a DC multi-target hybrid sputtering operation is performed on the surface shown in Fig. 2B to deposit the resistor layer 130. In some embodiments, the DC multi-target hybrid sputtering operation includes sputtering Ni-Cr alloy (NiCr₄₄), tantalum (Ta) and molybdenum (Mo). In some embodiments, the DC multi-target hybrid sputtering operation includes accessing gas such as argon into a sputtering chamber, and a pressure of the sputtering chamber is about 5×10⁻³ torr to about 8×10⁻² torr. In some embodiments, a sputtering power of the tantalum is about 60% to about 100% times a sputtering power of the Ni-Cr alloy, and a sputtering power of the molybdenum is about 5% to about 30% of the sputtering power of the Ni-Cr alloy. With the aforementioned sputtering power, the obtained resistor layer 130 includes Ni-Cr alloy in a range from about 45 wt% to about 75 wt%, tantalum in a range from about 20 wt% to about 40 wt% and molybdenum in a range from 5 wt% to 15 wt%. As discussed above, the specific amount range can make the resistor layer 130 have suitable resistance value and moisture-resistance.

In some examples, the sputtering power of the Ni-Cr alloy is 0.6 kW, the sputtering power of the tantalum is 0.6 kW, and the sputtering power of the molybdenum is 0.15 kW; thus, the obtained resistor layer 130 includes 55 wt% of the Ni-Cr alloy, 37 wt% of tantalum and 8 wt% of molybdenum.

Then, an RF-DC hybrid sputtering operation is performed to deposit a doping layer over the resistor layer 130. The RF-DC hybrid sputtering operation begins with heating the substrate 105 to about 150°C to about 250°C in a chamber, and such temperature should be lower than a glass ink curing temperature of the mask layer 210A. Subsequently, turn on the RF target and DC target to perform sputtering. In some embodiments, the RF-DC hybrid sputtering operation includes RF sputtering silicon and DC sputtering aluminum, in which a sputtering power of the aluminum is about 20% to about 50% times a sputtering power of the silicon. In such embodiments, a weight ratio of the aluminum and the silicon in the doping layer is about 1:1 to about 1:5. The aforementioned power range and the weight ratio of the aluminum and the silicon can help form the doping layer with suitable thickness. In some embodiments, an average thickness of the doping layer is in a range from about 0.005 µm to about 0.05 µm, and such thickness can have better doping effect.

After forming the doping layer, the mask layer 210A is removed by using a chemical solvent or deionized water, thus exposing a portion of the first inner electrode pair 120.

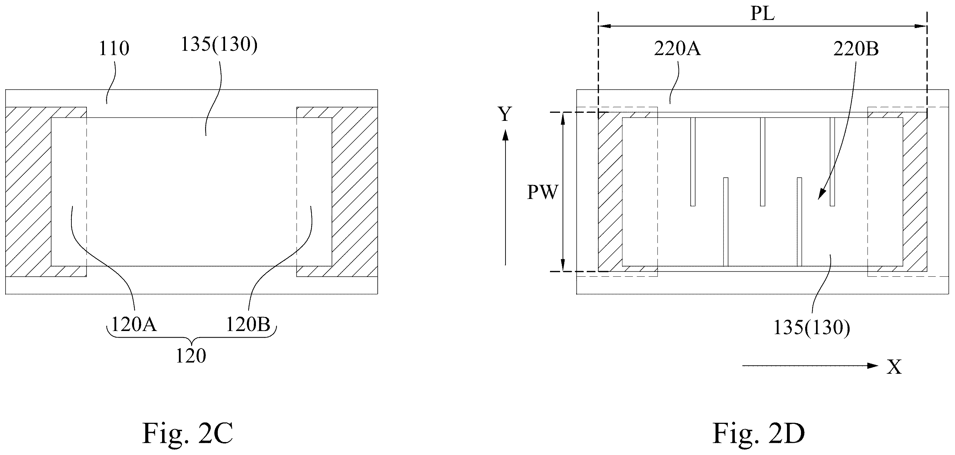

Referring to Fig. 2C, an annealing operation is performed on the doping layer in an atmospheric high-temperature furnace with a temperature of about 300°C to 600°C and a duration time in a range from about 2 hours to about 6 hours. With such annealing operation, part of the silicon and the aluminum within the doping layer can diffuse into the resistor layer 130, thereby forming silicon oxide (SiO₂) and the aluminum oxide (Al₂O₃) and forming an oxidized doping film 135 on the resistor layer 130. The oxidized doping film 135 formed by the annealing operation can help adjust the TCR and the resistivity. As shown in plot 300, different annealing temperature can be used to obtain different TCR. In some examples, when the annealing temperature is 450°C, and the duration time is 3 hours, the thin film resistor 100 has the TCR lower than 50 ppm and the resistivity of 1383 µΩ-cm.

Subsequently, a resistance adjusting step is performed on the resistor layer 130 and the oxidized doping film 135 above it, and the resistance adjusting step can use laser or physical processing to adjust the resistance of the resistor. After the resistance adjusting step, an atmospheric low-temperature heat treatment is performed to eliminate thermal effect produced from the physical process and micro-arc oxidation at resistor processed cross section. In some embodiments, the atmospheric low-temperature heat treatment is performed with a temperature in a range from about 200°C to about 350°C and a duration time in a range from about 0.5 hour to about 3 hours. In an example, after performing the resistance adjusting step by laser, the heat treatment is performed at 270°C for 1.5 hours.

Referring to Fig. 2D, a mask layer 220A is formed around the insulated oxidized film 110 and on a portion of the first inner electrode pair 120 so as to expose an area 220B to be passivated. In some embodiments, the mask layer 220A is removable glass ink formed by, for example, printing, coating or film laminating. The size of the area 220B to be passivated should make the following formed passivation layer 140 cover the resistor layer 130 (and the oxidized doping film 135) completely. In some embodiments, the area 220B to be passivated has a length PL in the direction X about 3/4 to about 4/5 times the length L, and a width PW in the direction Y about 4/5 to about 1 times the width W.

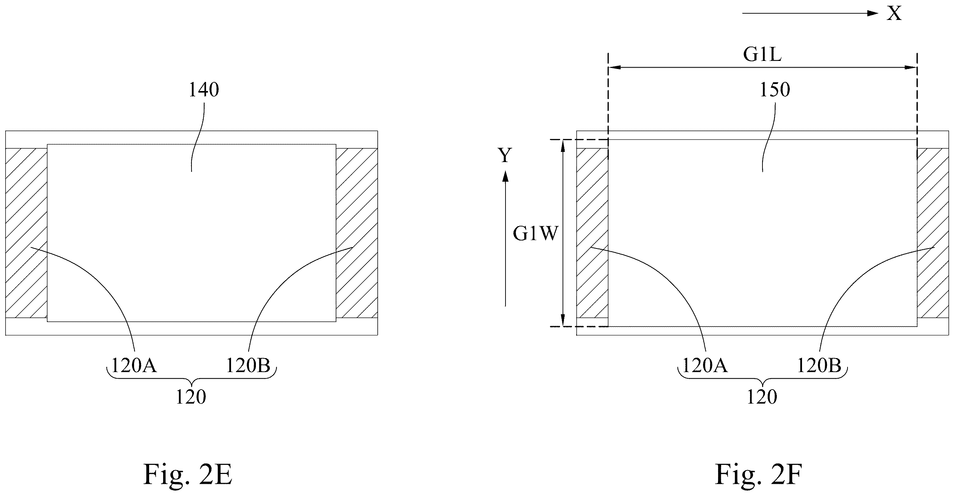

Subsequently, the passivation layer 140 is formed on the oxidized doping film 135 and the mask layer 220A. In some embodiments, the passivation layer 140 can be formed by using sputtering or chemical vapor deposition. Then, the mask layer 220A is removed by using the chemical solvent or deionized water; thus, the passivation layer 140 is formed on the oxidized doping film 135 and a portion of the first inner electrode pair 120, as shown in Fig. 2E.

Referring to Fig. 2F, the first insulated protective layer 150 is formed to cover the passivation layer 140. The first insulated protective layer 150 is configured to protect the passivation layer 140 and the first inner electrode pair 120. In some embodiments, the first insulated protective layer 150 is formed by printing or photolithography. In some embodiments, the first insulated protective layer 150 has a length G1L in the direction X in a range from (length L-250) µm to (length L-100) µm, and a width G1W in the direction Y about 4/5 to about 1 times the width W.

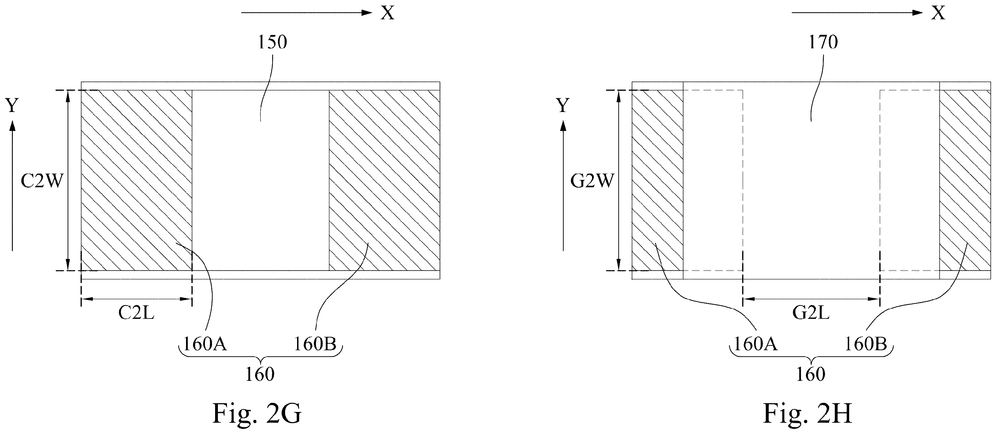

Referring to Fig. 2G, a second inner electrode 160A and a second inner electrode 160B (hereinafter referred to as the second inner electrode pair 160 in combination) are formed on the two ends of the insulated oxide film 110 and cover the first inner electrode pair 120 and a portion of the first insulated protective layer 150. In some embodiments, the second inner electrode pair 160 can be formed by printing. The second inner electrodes 160A and 160B have length C2L along the direction X and width C2W along the direction Y, respectively. In some embodiments, the length C2L is about 1/4 to about 1/3 times the length L, and the width C2W is about 4/5 to about 1 times the width W.

Referring to Fig. 2H, the second insulated protective layer 170 is formed on the first insulated protective layer 150 and the second inner electrode pair 160. The second insulated protective layer 170 is configured to protect the first insulated protective layer 150 and the second inner electrode pair 160. In some embodiments, the second insulated protective layer 170 is formed by printing or photolithography. In some embodiments, the second insulated protective layer 170 has a length G2L in the direction X about 1/3 to about 2/3 times the length L, and a width G2W in the direction Y about 4/5 to about 1 times the width W.

Referring to Fig. 2I, a back electrode 180A and a back electrode 180B (hereinafter referred to as the back electrode pair 180 in combination) are formed on the two ends of the lower surface 105B of the substrate. In some embodiments, the back electrode 180A and the back electrode 180B are formed by printing. The back electrode 180A and the back electrode 180B have length BCL along the direction X and width BCW along the direction Y, respectively. In some embodiments, the length BCL is about 1/4 to about 1/3 times the length L, and the width BCW is about 4/5 to about 1 times the width W.

Referring to Fig. 1 again, after the processes of Figs. 2H and 2L, the connected layer 185 is formed on the side portions 105C of the substrate 105. In some embodiments, the connected layer 185 is formed by sputtering. Subsequently, the nickel layer 190A and the tin layer 190B (hereinafter referred to as the outer electrode pair 190 in combination) are sequentially formed from the second insulated protective layer 170 along the connected layer 185 to cover the back electrode pair 180. In some embodiments, the outer electrode pair 190 is formed by electroplating.

According to above, the thin film resistor and the method of forming the same are provided. The resistor layer including different metals is deposited by using the DC multi-target hybrid sputtering operation, and the doping layer is deposited on the resistor layer by using the RF-DC hybrid sputtering operation, thereby controlling the resistance value and resistivity of the thin film resistor.

Although the present invention has been described in considerable detail with reference to certain embodiments thereof, other embodiments are possible. Therefore, the spirit and scope of the appended claims should not be limited to the description of the embodiments contained herein.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims.

## Claims

1. A method of forming a thin film resistor (100), comprising:
forming an insulated oxide film (110) on an upper surface of a substrate (105);
forming a first inner electrode pair (120) on two ends of the insulated oxide film (110);
performing a DC multi-target hybrid sputtering operation to deposit a resistor layer (130) on a portion of the insulated oxide film (110) and a portion of the first inner electrode pair (120), wherein the DC multi-target hybrid sputtering operation comprises sputtering Ni-Cr alloy, tantalum and molybdenum;
performing an RF-DC hybrid sputtering operation to deposit a doping layer over the resistor layer (130), wherein the RF-DC hybrid sputtering operation comprises RF sputtering silicon and DC sputtering aluminum;
performing an annealing operation so as to oxidize the doping layer to form an oxidized doping film (135); and
forming a passivation layer (140) on the oxidized doping film (135).

2. The method of claim 1, wherein forming the insulated oxide film (110) comprises:
forming a sputtering layer on the substrate, wherein the sputtering layer comprises tantalum or silicon; and
sintering the sputtering layer to form the insulated oxide film (110), wherein the insulated oxide film comprises tantalum oxide or silicon oxide.

3. The method of any one of claims 1-2, wherein when performing the DC multi-target hybrid sputtering operation, a sputtering power of the tantalum is 60% to 100% of a sputtering power of the Ni-Cr alloy, and a sputtering power of the molybdenum is 5% to 30% of the sputtering power of the Ni-Cr alloy.

4. The method of any one of claims1-3, wherein when performing the RF-DC hybrid sputtering operation, a sputtering power of the aluminum is 20% to 50% of a sputtering power of the silicon.

5. The method of any one of claims 1-4, wherein based on weight of the resistor layer as 100 wt%, the resistor layer comprises:
45 wt% to 75 wt% of the Ni-Cr alloy;
20 wt% to 40 wt% of the tantalum; and
5 wt% to 15 wt% of the molybdenum.

6. The method of any one of claims 1-5, wherein a weight ratio of the aluminum and the silicon in the doping layer is 1:1 to 1:5.

7. The method of any one of claims 1-6, further comprising:
forming a first insulated protective layer (150) on the passivation layer (140); and
forming a second inner electrode pair (160) on the ends of the insulated oxide film (110), wherein the first inner electrode pair (120) and a portion of the first insulated protective layer (150) are covered by the second inner electrode pair (160).

8. The method of claim 7, further comprising:
forming a second insulated protective layer (170) on an exposed portion of the first insulated protective layer (150) and a portion of the second inner electrode pair (160).

9. The method of claim 8, further comprising:
forming a back electrode pair (180) on two ends of a lower surface of the substrate (105); and
forming an outer electrode pair (190) from the second insulated protective layer (170) to the back electrode pair (180) along two side portions of the substrate (105).

10. A thin film resistor, formed by the method of any one of claims 1-9.

11. A method of forming a thin film resistor, comprising:
forming an insulated oxide film (110) on an upper surface of a substrate (105);
forming a first inner electrode pair (120) on two ends of the insulated oxide film (110);
performing a DC multi-target hybrid sputtering operation to deposit a resistor layer (130) on a portion of the insulated oxide film (110) and a portion of the first inner electrode pair (120);
performing an RF-DC hybrid sputtering operation to deposit a doping layer over the resistor layer (130);
performing an annealing operation so as to oxidize the doping layer to form an oxidized doping film (135), wherein the oxidized doping film comprises aluminum oxide and silicon oxide;
forming a passivation layer (140) on the oxidized doping film (135);
forming a first insulated protective layer(150) on the passivation layer (140); and
forming a second inner electrode pair (160) on the ends of the insulated oxide film (110).

12. The method of claim 11, wherein the DC multi-target hybrid sputtering operation comprises sputtering Ni-Cr alloy, tantalum and molybdenum.

13. The method of any one of claims 11-12, wherein the RF-DC hybrid sputtering operation comprises RF sputtering silicon and DC sputtering aluminum, and a weight ratio of aluminum and silicon in the doping layer is 1:1 to 1:5.

14. The method of any one of claims 11-13, wherein the annealing operation is performed with a heating temperature in a range from 300°C to 600°C and a duration time in a range from 2 hours to 6 hours.

15. The method of any one of claims 11-14, wherein the resistor layer has a thickness in a range from 0.02 µm to 0.5 µm, and the doping layer has a thickness in a range from 0.005 µm to 0.05 µm.
